**Europäisches Patentamt**

**European Patent Office**

**Office européen des brevets**

(19)

(11) Veröffentlichungsnummer: **0 258 841**
**B1**

(12) **EUROPÄISCHE PATENTSCHRIFT**

(45) Veröffentlichungstag der Patentschrift:
04.07.90

(21) Anmeldenummer: 87112560.5

(22) Anmeldetag: 28.08.87

(51) Int. Cl.⁵: **H03M 1/38**

(54) **Analog-Digital-Umsetzer nach dem Wägeverfahren.**

(30) Priorität: 02.09.86 DE 3629830

(43) Veröffentlichungstag der Anmeldung:
09.03.88 Patentblatt 88/10

(45) Bekanntmachung des Hinweises auf die Patenterteilung:
04.07.90 Patentblatt 90/27

(84) Benannte Vertragsstaaten:
AT BE CH DE FR GB IT LI LU NL SE

(56) Entgegenhaltungen:
E.D.N. ELECTRICAL DESIGN NEWS, Band 31, Nr. 6, 20. März 1986, Seiten 191-198, Boston, Massachusetts, US; J. WILLIAMS: "Build your own A/D converter for optimum performance"
E.D.N. ELECTRICAL DESIGN NEWS, Band 20, Nr. 14, 20. Juni 1985, Seiten 115-128, Boston, Massachusetts, US; J. WILLIAMS: "Fast comparator IC speeds converters and S/H amplifiers"
INTERNATIONAL JOURNAL OF ELECTRONICS, Band 37, Nr. 5, 22. März 1974, Seiten 711-713, London, GB; S. MANICKAVASAGAN et al.: "On extending the range of an analogue-digital converter inexpensively"
RADIO FERNSEHEN ELEKTRONIK, Band 24, Nr. 21, 1. November 1975, Seiten 685-690, Ost-Berlin, DD; H. KOBER et al.: "Analogue-to-digital converter of 10 digit resolution and automatic null point control"

(73) Patentinhaber: **Siemens Aktiengesellschaft, Wittelsbacherplatz 2, D-8000 München 2(DE)**

(72) Erfinder: **Oitzl, Erich, Dipl.-Ing., Jungnickelstrasse 5, A-8500 Villach(AT)**
Erfinder: **Haas, Manfred, Dipl.-Ing., Heidenfeldstrasse 21, A-8500 Villach(AT)**

**Beschreibung**

Die Erfindung betrifft einen Analog-Digital-Umsetzer nach dem Oberbegriff des Patentanspruchs 1.

Ein derartiger Analog-Digital-Umsetzer ist beispielsweise in dem Buch "Halbleiter-Schaltungstechnik" von U. Tietze und Ch. Schenk, 7., überarbeitete Auflage, Springer-Verlag Berlin, Heidelberg, New York, 1985, S. 767 ff. beschrieben.

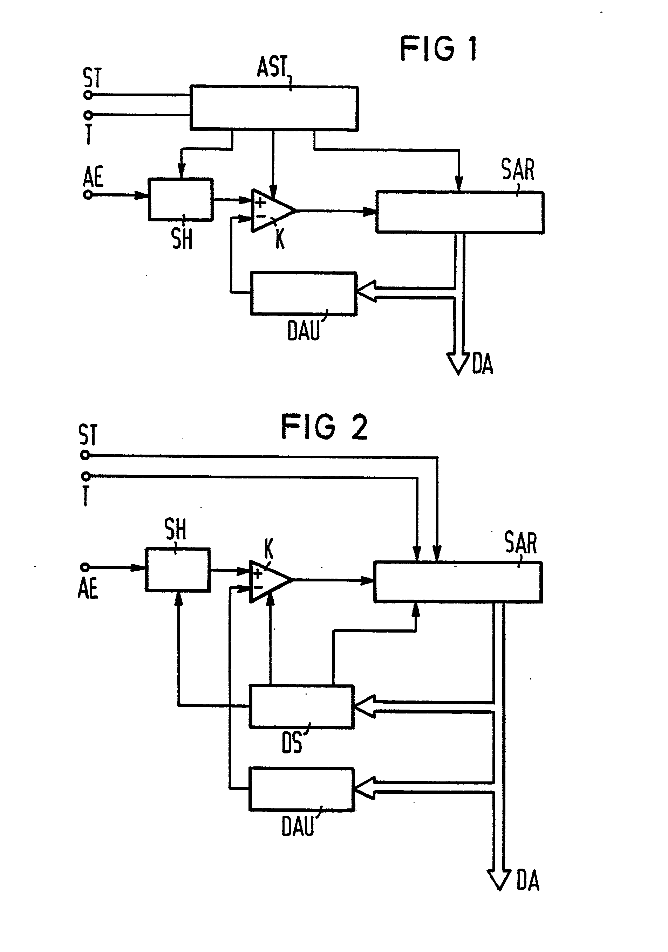

Gemäß Fig. 1 enthält ein somit bekannter Analog-Digital- Umsetzer ein Abtast-Halte-Glied SH, einen Komparator K, ein sukzessives Approximations-Register SAR, einen Digital-Analog-Umsetzer DAU sowie eine Ablaufsteuerung AST. Das Abtast-Halte-Glied SH dient zur Zwischenspeicherung des am Analogeingang AE liegenden Spannungswertes während der Umwandlungszeit, damit alle Stellen des am Datenausgang DA nach der Umwandlung anliegenden Ausgangswortes von derselben Eingangsspannung gebildet werden. Der Komparator K vergleicht den im Abtast-Halte-Glied SH gespeicherten Meßwert mit der Ausgangsspannung des Digital-Analog-Umsetzer DAU.

Mit Beginn der Wandlung einer analogen Eingangsspannung werden die Speicherelemente des sukzessiven Approximations-Registers rückgesetzt, so daß das digitale Ausgangswort am Datenausgang DA des sukzessiven Approximations-Registers SAR gleich Null ist. Anschließend wird das höchstwertige Bit auf einen definierten logischen Zustand, insbesondere logisches Einspotential gesetzt und geprüft, ob die Eingangsspannung bzw. die Ausgangsspannung des Abtast-Halte-Gliedes SH höher als die Ausgangsspannung des Digital-Analog-Umsetzers DAU ist, die dem digitialen Wort des sukzessiven Approximations-Registers entspricht. Ist das der Fall, bleibt es gesetzt, anderenfalls wird es gelöscht. Dieser Wägevorgang wird für jedes Bit wiederholt, bis am Ende der Konversionsphase auch das niederwertigste Bit feststeht.

Das sukzessive Approximations-Register enthält ein Schieberegister, in dem der definierte logische Zustand bei jedem Takt um eine Position weitergeschaltet wird. Dadurch werden die Bits der Reihe nach versuchsweise auf den definierten logischen Zustand gesetzt. Das jeweilige Wägeresultat wird ebenfalls in Speicherelementen gespeichert, in die der betreffende Komparatorzustand eingelesen wird. Dabei wird nur dasjenige Speicherelement freigegeben, dessen zugehöriges Bit gerade getestet wird. Nach der Festlegung des niederwertigsten Bits wird in der Regel ein weiteres Speicherelement des Schieberegisters gesetzt, damit angezeigt wird, daß die Konversionsphase abgeschlossen ist.

Die Konvertierung und eventuell die Signalabtastung und Speicherung erfordern eine Steuerung, die üblicherweise mit Hilfe einer Ablaufsteuerung AST gemäß Fig. 1 erfolgt. Die Ablaufsteuerung AST setzt die an den Eingängen ST und T liegenden Start- und Taktsignale zur Steuerung des Komparators K und der Funktionen des sukzessiven Approximations-Registers SAR sowie gegebenenfalls des Abtast-Halte-Gliedes SH um. Dazu benötigt die Ablaufsteuerung AST gewöhnlich einen Steuerzähler mit Decoder.

Der Erfindung liegt die Aufgabe zugrunde, den Steuerungsaufwand für einen gattungsgemäßen Analog-Digital-Umsetzer zu verringern.

Diese Aufgabe wird bei einem Analog-Digital-Umsetzer der eingangs genannten Art erfindungsgemäß durch die Merkmale des kennzeichnenden Teils des Patentanspruchs 1 gelöst.

Der Erfindung liegt der Gedanke zugrunde, das sukzessive Approximations-Register selbst in Verbindung mit einem Decoder zur Ablaufsteuerung einzusetzen. Dabei wird die spezielle Eigenschaft des sukzessiven Approximations-Registers SAR genutzt, daß nach einem Startsignal zu Beginn der Konversionsphase ein definierter logischer Zustand, beginnend mit dem höchstwertigen Bit, in Abhängigkeit eines Taktes stufenweise weitergeschaltet wird. Die Erläuterung der Erfindung erfolgt anhand von Fig. 2, in der gleiche Elemente wie in Fig. 1 mit gleichen Bezugszeichen versehen sind.

Erfindungsgemäß wird das sukzessive Approximations-Register SAR direkt über die Eingänge ST und T von den Start- bzw. Taktsignalen angesteuert. Anstelle einer speziellen Ablaufsteuerung weist der Analog-Digital-Umsetzer erfindungsgemäß einen Decoder DS auf, der eingangsseitig mit dem Datenausgang DA bzw. mit dem Ausgang des sukzessiven Approximations-Registers SAR verbunden ist. Ausgangsseitig steuert dieser Decoder DS den Komparator, das sukzessive Approximations-Register SAR selbst und gegebenenfalls das Abtast-Halte Glied SH.

Der Decoder DS decodiert insbesondere den mit jedem Taktsignal im sukzessiven Approximations-Register SAR weitergeschalteten definierten logischen Zustand und nutzt das Ergebnis der Decodierung zur Steuerung der angeführten Elemente. Konkrete Ausführungen des Decoders DS zur Steuerung der Funktionen Weiterschalten des definierten logischen Zustands, Einschreiben und Speichern des Wägeresultats des Komparators im sukzessiven Approximations-Register SAR sowie der beiden übrigen Elemente sind für den Durchschnittsfachmann leicht realisierbar.

**Patentansprüche**

1. Taktgesteuerter Analog-Digital-Umsetzer nach dem Wägeverfahren mit einem Abtast-Halteglied (SH) mit Analogeingang, einem Komparator (K) sowie einem sukzessiven Approximations-Register (SAR) mit Datenausgang (DA), die hintereinander angeordnet sind, wobei das sukzessive Approximations-Register Speicherelemente zum Weiterschalten eines definierten logischen Zustands für jeden sukzessiven Wägeschritt sowie zum Einschreiben und Speichern des jeweiligen, vom Komparator ermittelten Wägeresultats enthält, und mit einem eingangsseitig mit dem Datenausgang verbundenen Digital-Analog-Umsetzer (DAU), der ausgangsseitig an einem Eingang des Komparators liegt, **dadurch gekennzeichnet,** daß der Komparator (K) und das sukzessive Approximations-Register (SAR) von einem Decoder (DS) gesteuert werden, der eingangsseitig mit dem Datenausgang (DA) verbunden ist.

2. Analog-Digital-Umsetzer nach Anspruch 1, **dadurch gekennzeichnet,** daß das Abtast-Halte-Glied (SH) vom Decoder (DS) gesteuert wird.

3. Analog-Digital-Umsetzer nach Anspruch 1 oder 2, **dadurch gekennzeichnet,** daß der Decoder (DS) den weitergeschalteten definierten logischen Zustand des sukzessiven Approximations-Registers (SAR) decodiert und das Ergebnis der Decodierung zur Steuerung des Komparators (K), des sukzessiven Approximations-Registers (SAR) und gegebenenfalls des Abtast-Halte-Gliedes (SH) verwendet.

**Claims**

1. Clock-controlled analog to digital converter operating according to the weighing method having a sample and hold (SH) with analog input, a comparator (K) and a successive approximation register (SAR) with data output (DA) which are arranged in series, the successive approximation register containing memory elements for incrementing a defined logical state for each successive weighing step as well as for writing in and storing the respective weighing result determined by the comparator, and having a digital to analog converter (DAU) connected on the input side to the data output and connected on the output side to an input of the comparator, characterized in that the comparator (K) and the successive approximation register (SAR) are controlled by a decoder (DS) which is connected on the input side to the data output (DA).

2. Analog to digital converter according to Claim 1, characterized in that the sample and hold member (SH) is controlled by the decoder (DS).

3. Analog to digital converter according to Claim 1 or 2, characterized in that the decoder (DS) decodes the incremented defined logical state of the successive approximation register (SAR) and uses the result of the decoding for controlling the comparator (K), the successive approximation register (SAR) and if required the sample and hold member (SH).

**Revendications**

1. Convertisseur analogique/numérique commandé de façon cadencée, fonctionnant selon le procédé de pondération et comportant un circuit d'échantillonnage et de maintien (SH) possédant une entrée analogique, un comparateur (K) ainsi qu'un registre d'approximations successives (SAR) comportant une sortie de données (DA), ces unités étant montées en série, le registre d'approximations successives contenant des éléments de mémoire servant à faire avancer un état logique défini pour chaque pas successif de pondération ainsi que pour l'enregistrement et la mémorisation du résultat respectif de pondération déterminé par le comparateur, et comportant un convertisseur numérique/analogique (DAU), dont l'entrée est raccordée à la sortie de données et dont la sortie est raccordée à une entrée du comparateur, caractérisé par le fait que le comparateur (K) et le registre d'approximations successives (SAR) sont commandés par un décodeur (DS), dont l'entrée est raccordée à la sortie de données (DA).

2. Convertisseur analogique/numérique suivant la revendication 1, caractérisé par le fait que le circuit d'échantillonnage et de maintien (SH) est commandé par le décodeur (DS).

3. Convertisseur analogique/numérique suivant les revendications 1 ou 2, caractérisé par le fait que le décodeur (DS) décode l'état logique défini avancé du registre d'approximations successives (SAR) et utilise le résultat du décodage pour commander le comparateur (K), le registre d'approximations successives (SAR) et éventuellement le circuit d'échantillonnage et de maintien (SH).

FIG 1

FIG 2